# EUROPEAN PATENT APPLICATION

(11) **EP 1 688 776 A1**
(43) Date of publication of application: **09.08.2006**
(21) Application number: 06250601.9
(22) Date of filing: 03.02.2006
(51) Int. Cl.: G02B 26/08, B81B 7/00

(54) **Optical scanner package and method of manufacturing the same**

(30) Priority: 07.02.2005 KR 2005011416
(71) Applicant: Samsung Electronics Co., Ltd., Suwon-si, Gyeonggi-Do (KR)
(72) Inventor: Choi, Won-kyoung, Yeongtong-gu, Suwon-si, Gyeonggi-do (KR); Mun, Yong-kweun, Giheung-gu, Yongin-si, Gyeonggi-do (KR); Ko, Young-chul, Giheung-gu, Yongin-si, Gyeonggi-do (KR)
(74) Representative: Greene, Simon Kenneth

(57) **Abstract**

Provided are a chip-scale optical scanner package with reduced noise, and a method of manufacturing the optical scanner package. The optical scanner package includes: an optical scanner device scanning an incident beam, the optical scanner device including a mirror portion, comb-electrode structures rotating the mirror portion, and a base substrate; and a cover glass protecting the mirror portion, the cover glass including support portions sealingly adhered to a top surface of the base substrate around the mirror portion and a transmission portion with first and second transmission surfaces formed on the support portions and sloped with respect to a top surface of the base substrate. Accordingly, the optical scanner package can be miniaturized, can be simply processed, and reduce packaging costs. Further, the brightness and contrast of an image can be enhanced, and background noise can be reduced by reducing a sub reflected beam that causes noise.

## Description

The present invention relates to an optical scanner package including a micro-electro-mechanical system (MEMS) micromirror and a method of manufacturing the optical scanner package, and more particularly, to a chip-scale optical scanner package, which can produce an image with reduced noise, and a method of manufacturing the optical scanner package.

Micro-electro-mechanical system (MEMS) based optical scanners using an electrostatic effect caused by comb-typed electrode structures have been used for deflecting a laser beam in projection televisions and the like. Since the size of a mirror of such optical scanners is less than several millimeters, the optical scanners are very sensitive to the external environment. Accordingly, to maintain the performance of the optical scanners and protect the optical scanners from an environmental change, a hermetically sealed package is necessary.

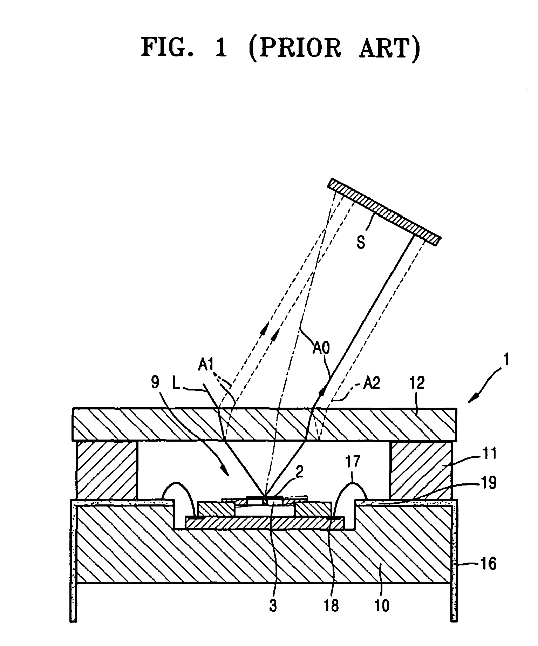

FIG. 1 is a schematic cross-sectional view of a conventional optical scanner package 1. The conventional optical scanner package 1 is configured such that an optical scanner device 9 is die-bonded to a top surface of a package substrate 10. After the optical scanner device 9 is mounted on the top surface of the package substrate 10, each of wires 17 is connected between an electrode pad 18 of the optical scanner device 9 and an electrode pad 19 disposed at an inner wall of the package substrate 10. The electrode pad 19 of the package substrate 10 is connected to a lead 16 downwardly protruding from the package substrate 10 to receive an external voltage. Further, a cover glass 12 is adhered to a sidewall 11 formed along the edge of the top surface of the package substrate 10 to completely seal the optical scanner device 9 from the outside of the optical scanner package 1.

A conventional method of manufacturing the optical scanner package 1 requires a process of die-bonding the optical scanner device 9 to the package substrate 10, a process of connecting the wire 17 between the package substrate 10 and the optical scanner device 9, and a process of adhering the cover glass 12 to the sidewall 11 of the package substrate 10 to completely seal the optical scanner device 9 from the outside.

Accordingly, the above manufacturing processes are complex and time-consuming and expensive. Moreover, since bonding is performed many times and many kinds of solders are used at each step, the reliability of the optical scanner device 9 is affected, and since the number of processes is high, the yield is low. In addition, since the package 1 surrounding the optical scanner device 9 is two to four times larger than a real optical scanner device, the package 1 cannot be miniaturized.

In the meantime, when a laser beam is incident on and reflected by an optical scanner, sub reflected beams may cause problems as shown in FIG. 1.

Since the optical scanner device 9 is sealed as described above, a laser beam L is transmitted through the cover glass 12 of the package 1 and then incident on a mirror 2. Most of the laser beam L incident through the cover glass 12, that is, a main reflected beam A0, is reflected by the mirror 2 formed on a top surface of a mirror portion 3 to be scanned to a screen S. A path in which the main reflected beam A0 is scanned to the screen S is marked by a solid line and a dashed dot line as shown in FIG. 1.

In this procedure, part of the incident laser beam L, that is, a first sub reflected beam A1, is reflected by a top surface and a bottom surface of the cover glass 12 before reaching the mirror 2. An optical path of the first sub reflected beam A1 reflected by the cover glass 12 is marked by a dotted line as shown in FIG. 1.

Further, part of the beam reflected by the mirror 2, that is, a second sub reflected beam A2, is not directly transmitted through the cover glass 12 but is reflected again inside the cover glass 12 and then scanned to the screen S. An optical path of the second sub reflected beam A2 reflected again inside the cover glass 12 is marked by a dotted line as shown in FIG. 1.

The first and second sub reflected beams A 1 and A2 incident on the screen S badly affect an image formed on the screen S by the normally scanned main reflected beam A0.

The present invention provides a chip-scale optical scanner package that has an improved beam separation structure so that a sub reflected beam causing noise is prevented from being directed to a screen.

The present invention provides a method of simply manufacturing the chip-scale optical scanner package having the above structure.

According to an aspect of the present invention, there is provided an optical scanner package comprising: an optical scanner device scanning an incident beam, the optical scanner device including a mirror portion, comb-electrode structures rotating the mirror portion, and a base substrate; and a cover glass protecting the mirror portion, the cover glass including support portions sealingly adhered to a top surface of the base substrate around the mirror portion and a transmission portion with first and second transmission surfaces formed on the support portions and sloped with respect to a top surface of the base substrate.

The slope between the first and second transmission surfaces and the base substrate may be greater than a maximum rotation angle of the mirror portion.

An anti-reflection layer may be formed on the first transmission surface and/or the second transmission surface.

The optical scanner package may further comprise an absorption layer formed at portions of the first transmission surface and/or the second transmission surface not covered by a transmission area.

Through-holes in which a conductive metal delivering voltage for rotating the mirror portion may be formed in the base substrate.

According to another aspect of the present invention, there is provided a method of manufacturing an optical scanner package, comprising: forming an optical scanner device by stacking a mirror portion and comb-electrode structures for rotating the mirror portion on a wafer that forms a base substrate; forming a cavity so that the optical scanner device can include support portions installed on a top surface of the base substrate around the mirror portion and a transmission portion with first and second transmission surfaces formed on the support portions, and processing a cover glass by making the thickness at one side of the support portions less than the thickness at the other side of the support portions so that the first and second transmission surfaces can be sloped with respect to the top surface of the base substrate; and hermetically sealing the mirror portion in a chip scale by adhering the top surface of the base substrate to bottom surfaces of the support portions.

The forming of the optical scanner device may comprise cutting the wafer in columns, the wafer being arranged in a matrix form.

The processing of the cover glass may comprise: planarizing and polishing both surfaces of a glass wafer; forming a plurality of cavities arranged in a matrix form at the bottom surface of the glass wafer; cutting the glass wafer in columns and preparing a glass bar; and cutting and polishing a bottom surface of the glass bar by making a thickness at one side of the support portions less than a thickness at the other side of the support portions so that the slope between the transmission surfaces and the top surface of the base substrate can be greater than a maximum rotation angle of the mirror portion.

The processing of the cover glass may comprise forming an anti-reflection layer on a top surface and/or a bottom surface of the cover glass.

The processing of the cover glass may comprise forming an absorption layer at an edge of a top surface and/or a bottom surface of the cover glass.

The hermetically sealing of the mirror portion may comprise eutectic-bonding the cover glass and the optical scanner device in a wafer bar shape.

The above and other features and advantages of the present invention will become more apparent by describing in detail exemplary embodiments thereof with reference to the attached drawings in which:
**FIG. 1** is a schematic cross-sectional view of a conventional optical scanner package;
FIG. 2 is a cross-sectional view of an optical scanner package according to an embodiment of the present invention;
FIGS. 3 and 4 are cross-sectional views illustrating the operation of an optical scanner package according to an embodiment of the present invention;
FIGS. 5A and 5B are views illustrating a method of manufacturing an optical scanner device according to an embodiment of the present invention;
FIGS. 6A through 6G are views illustrating a method of manufacturing a cover glass of an optical scanner package according to an embodiment of the present invention; and
FIGS. 7A and 7B are views illustrating a process of hermetically sealing a chip-scale optical scanner package according to an embodiment of the present invention.

The present invention will now be described more fully with reference to the accompanying drawings, in which preferred embodiments of the invention are shown.

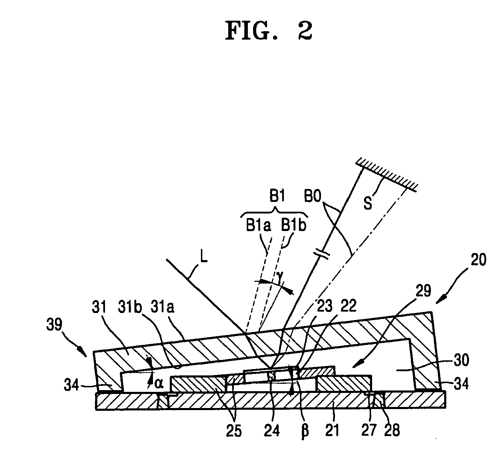

Referring to FIG. 2, an optical scanner package 20 according to an embodiment of the present invention is a hermetically sealed chip-scale package. The optical scanner package 20 includes an optical scanner device 29 scanning an incident beam, and a cover glass 39 directly adhered to a base substrate 21 of the optical scanner device 29 to protect the optical canner device 29.

The optical scanner device 29 includes the base substrate 21, a mirror portion 22 with a mirror 23 installed over the base substrate 21 to perform a seesaw motion, comb-electrode structures 25 rotating the mirror portion 22, and electrode structures 27 delivering external voltage to the comb-electrode structures 25.

A detailed structure and method of manufacturing the optical scanner device 29 is disclosed in Korean Patent Publication No. 2004-35116, and Korean Patent Application Nos. 2003-86624 and 2004-83537. However, the structure of the optical scanner device 29 according to the present invention and the method of manufacturing the same are not limited thereto.

Also, since the optical scanner device 29 is sealed in a chip-scale package, through-holes 28 in which a conductive material is filled to electrically connect external wires (not shown) and the electrode structures 27 are formed in the base substrate 21.

The cover glass 39 is made of a transparent material. Also, when the cover glass 39 is adhered to the optical scanner device 29, to secure a cavity 30 where the mirror portion 22 installed over the base substrate 21 can perform a seesaw motion, the cover glass 39 includes support portions 34 adhered to a top surface of the base substrate 21, and a transmission portion 31 disposed on the support portions 34. The transmission portion 31 includes a first transmission surface 31 a exposed to the outside of the optical scanner package 20, and a second transmission surface 31 b facing the optical scanner device 29. Here, the first and second transmission surfaces 31 a and 31 b are sloped respectively at an angle of "a" with respect to the top surface of the base substrate 21.

The optical scanner device 29 is turned on or off by an image signal controller (not shown) to reflect a laser beam L, which is emitted from a light source and transmitted through the transmission portion 31, by changing the rotation angle of the mirror portion 22 and scan the reflected laser beam L to a screen S.

Part of the emitted laser beam L is reflected by the first and second transmission surfaces 31 a and 31 b of the transmission portion 31 before reaching the mirror 23. Accordingly, when the beam reflected and scanned by the mirror 23 is referred to as a main reflected beam B0 and the beam reflected by the transmission portion 31 is referred to as a first sub reflected beam B1, the first sub reflected beam B1 propagates outside the screen S since the transmission portion 31 is sloped as described above.

The angle of the main reflected beam B0 incident on the screen S is varied depending on the rotation angle of the mirror portion 22 so that a scan line can be formed on the screen S. Accordingly, it is preferable that the main reflected beam B0 not be overlapped with the first sub reflected beam B1 while it is scanned to the screen S. To this end, a slope α should be greater than a maximum rotation angle β of the mirror portion 22. In this case, a minimum angle γ between the main reflected beam B0 and the first sub reflected beam B1 becomes greater than 0, and thus the first sub reflected beam B1 can be emitted to a position outside the effective area of the screen S. Here, since the maximum rotation angle β of the mirror portion 22 is related to the size of the screen S, the maximum rotation angle β may be varied depending on the design of the screen S.

Accordingly, the optical scanner package 20 according to the present invention can effectively prevent the first sub reflected beam B1 from being directed to the screen S by making the slope α between the cover glass 39 and the base substrate 21 greater than the maximum rotation angle β of the mirror portion 22.

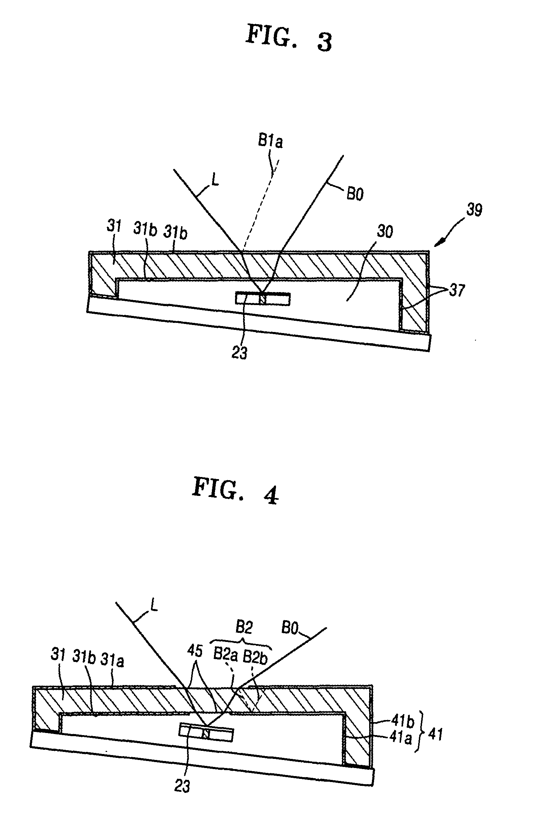

Also, an anti-reflection layer may be formed on the first transmission surface 31 a and/or the second transmission surface 31 b of the cover glass 39 to reduce the first sub reflected beam B1. Referring to FIG. 3, an anti-reflection layer 37 is formed on the cover glass 39 of the optical scanner package 20 of the present invention. The anti-reflection layer 37 may be formed on the first transmission surface 31 a or the second transmission surface 31 b, and preferably may be formed on both the first and second transmission surfaces 31 a and 31 b. As shown in FIG. 3, the anti-reflection layer 37 reduces the first sub reflected beam B1a, and thus the influence of the first sub reflected beam B1 on an image can be reduced further even when part of the first sub reflected beam B1 is incident on the effective area in the screen S.

Referring to FIG. 4, the laser beam reflected by the mirror 23 may include the main reflected beam B0 directly transmitted through the transmission portion 31 and then scanned to the screen S and also a second sub reflected beam B2 reflected inside the transmission portion 31 again to the screen S. To reduce the second sub reflected beam B2, it is preferable that an absorption layer 41 be further provided on portions of the first transmission surface 31 a and/ore the second transmission surface 31 b not covered by a transmission area 45 as shown in FIG. 4. The absorption layer 41 a formed on the second transmission surface 31 b absorbs a beam B2a of the second sub reflected beam B2 reflected by the first transmission surface 31 a.

An absorption layer 41 b may be further formed on the first transmission surface 31 a to absorb a beam B2b of the second sub reflected beam B2 internally reflected again by the second transmission surface 31 b. Accordingly, image noise due to the second sub reflected beam B2 can be reduced by minimizing beam reflection inside the transmission portion 31.

To stably maintain the hermetic sealing between the base substrate 21 and the cover glass 39 irrespective of an external temperature change, it is preferable that the cover glass 39 be made of a material so that the thermal expansion coefficient of the cover glass 39 can be the same as the thermal expansion coefficient of the base substrate 21.

A method of manufacturing the optical scanner package 20 according to an embodiment of the present invention will now be explained in detail with reference to the drawings. The drawings cited along with the descriptions of a manufacturing process are schematically shown for understanding, compared to the drawings for the above-described optical scanner device of the present invention.

The method of manufacturing the optical scanner package includes a process of manufacturing an optical scanner device, a process of a manufacturing cover glass capable of reducing image noise due to a sub reflected beam, and a process of hermetically sealing the optical scanner device to the cover glass in a chip scale.

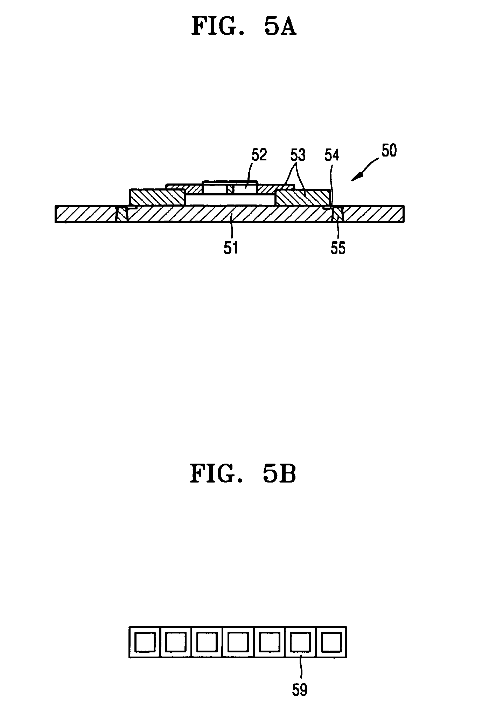

First, for the process of manufacturing the optical scanner device, a plurality of optical scanner devices 50 are simultaneously manufactured on a wafer using one typical semiconductor manufacturing process. Referring to FIG. 5, a mirror portion 52, comb-electrode structures 53 for rotating the mirror portion 52, and electrode structures 54 for delivering external voltage to the comb-electrode structures 53 are formed on a top surface of the wafer that forms a base substrate 51.

Since the optical scanner device 50 is sealed in a chip scale package by hermetic sealing, which will be explained later, the electrode structures 54 should be directly connected to external electrodes. Accordingly, before the electrode structures 54 are formed, the base substrate 51 should be etched to form through-holes 55. Thereafter, a conductive metal is filled in the through-holes 55.

To adhere the plurality of optical scanner devices manufactured on the wafer to a cover glass, the wafer is cut in columns to form a wafer bar 59 as shown in FIG. 5B.

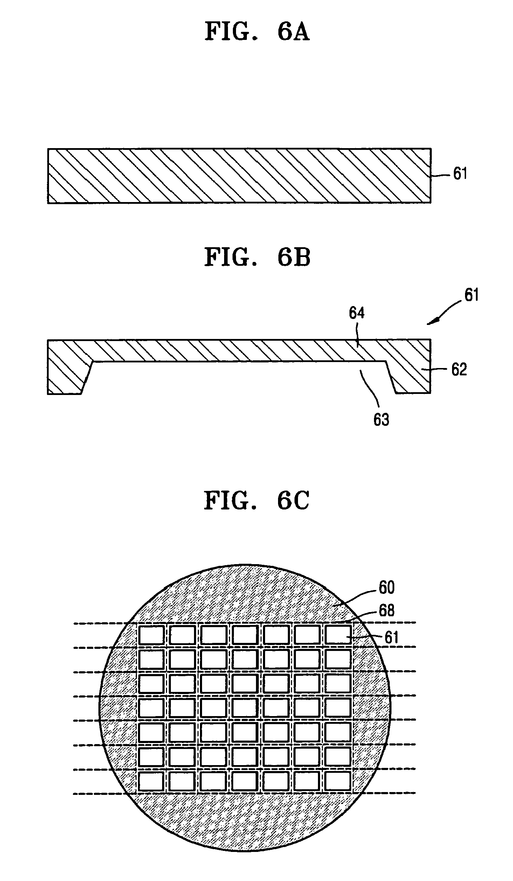

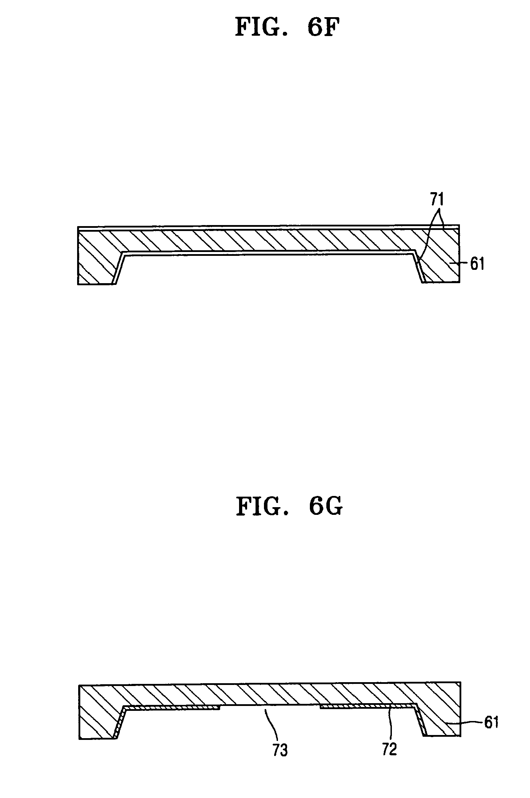

Next, referring to FIGS. 6A through 6G, the method of manufacturing the cover glass will now be explained. Here, a plurality of cover glasses are simultaneously manufactured on a wafer in one process. For convenience of explanation, FIGS. 6A, 6B, 6F, and 6G illustrate one separated cover glass.

Referring to FIG. 6A, a cover glass 61, that is, a glass wafer, is prepared and both surfaces of the cover glass 61 is polished and planarized.

Next, referring to FIG. 6B, a cavity 63 for securing a space where the mirror portion 52 (see FIG. 5A) of the optical scanner device 50 can perform a seesaw motion is formed at one surface of the cover glass 61. The cavity 63 may be formed by etching, for example, dry etching. After this process, the cover glass 61 can be divided into support portions 62 and a transmission portion 64.

Next, the support portions 62 are partially removed so that the transmission portion 64 can be sloped when the cover glass 61 is adhered to the base substrate 51 (see FIG. 5A). To this end, referring to FIG. 6C, the plurality of cover glasses 61 arranged in a matrix form on one glass wafer 60 are cut in columns to form a glass bar 68. When the glass bar 68 is processed, the plurality of cover glasses 61 can be simultaneously processed, thereby increasing efficiency.

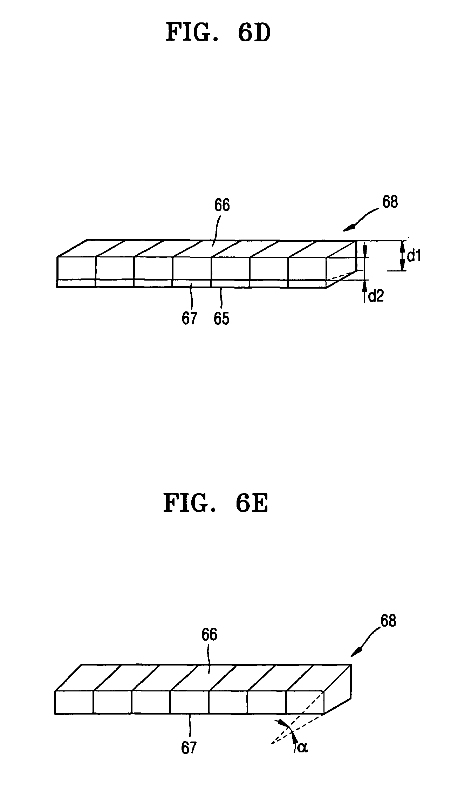

Next, referring to FIGS. 6D and 6E, a bottom surface 65 of the glass bar 68 is cut by making a thickness d2 at one side of the glass bar 68 less than a thickness d1 at the other side so that a top surface 66 of the glass bar 68 and the cut bottom surface 67 cannot be parallel to each other.

It is preferable that the thicknesses d1 and d2 be determined so that an angle between the top surface 66 and the bottom surface 67 of the glass bar 68 can be greater than a maximum rotation angle of the mirror portion 52. Here, the angle between the top surface 66 and the bottom surface 67 of the glass bar 68 is equal to a slope α between the cover glass and the base substrate 51 of the finally completed optical scanner package. After cutting, the cut bottom surface 67 is polished.

Next, referring to FIG. 6F, an anti-reflection layer 71 may be formed on at least one surface of the glass wafer 61.

Also, referring to FIG. 6G, an absorption layer 72 may be formed on at least one surface of the glass wafer 61. Here, since a transmission area 73 through which a laser beam is transmitted should be transparent, the absorption layer 72 is formed at portions not covered by the transmission area 73.

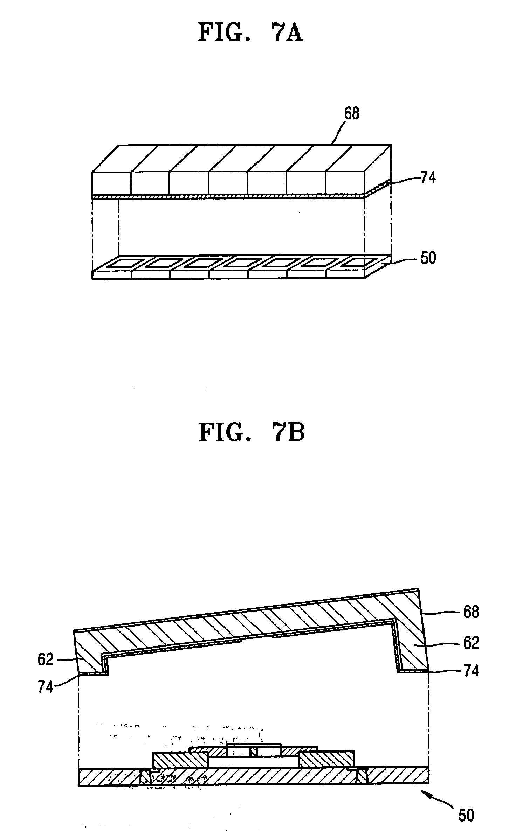

Next, referring to FIG. 7A and 7B, the bar-shaped optical scanner device and the bar-shaped cover glass are adhered to each other. To this end, a bonding layer 74 is formed at bottom surfaces of the support portions 62. The bonding layer 74 may be made of chrome (Cr) or gold (Au) to perform eutectic bonding. Although the bonding layer 74 is formed at the cover glass in the present embodiment illustrated in FIGS. 7A and 7B, the bonding layer 74 may be formed at the base substrate.

In the state where the bonding layer 74 is formed, the optical scanner device and the cover glass are adhered to each other. For example, after the bar-shaped optical scanner 50 and the bar-shaped cover glass 68 are fixed to different vacuum chucks, the two bars are aligned with observation through a microscope and then combined into one by making the two vacuum chucks closer. Here, by maintaining predetermined pressure and eutectic temperature, the eutectic bonding layer between the frames is melted and stuck. As a result, the two bars are combined into one. Subsequently, the combined structure is cut into respective devices to complete the optical scanner package as shown in FIG. 2.

As described above, since the optical scanner package according to the present invention can be manufactured in a chip scale, the optical scanner package can be made compact, can be simply manufactured, and can reduce packaging costs.

Furthermore, the brightness and contrast of the image can bee increased and background noise can be reduced by reducing the sub reflected beam that causes noise.

In addition, the optical scanner package manufacturing method according to the present invention can succeed in the fabrication of a desired optical scanner package, and can reduce manufacturing time and processes and a device defective rate by packaging the optical scanner devices in the wafer bar.

While the optical scanner package and the method thereof according to the present invention have been particularly shown and described with reference to exemplary embodiments thereof, it will be understood by those of ordinary skill in the art that various changes in form and details may be made therein without departing from the scope of the present invention as defined by the following claims.

## Claims

1. An optical scanner package (20) comprising:
an optical scanner device arranged to scan an incident beam, the optical scanner device including a mirror portion (22), comb-electrode structures (25) arranged to rotate the mirror portion (22), and a base substrate (21); and
a cover glass (39) arranged to protect the mirror portion (22), the cover glass (39) including support portions (34) sealingly adhered to a top surface of the base substrate (21) around the mirror portion and a transmission portion (31) with first and second transmission surfaces formed on the support portions (34) and sloped with respect to a top surface of the base substrate.

2. The optical scanner package of claim 1, wherein the slope between the first and second transmission surfaces (31 a, 31 b) and the base substrate (21) is greater than a maximum rotation angle of the mirror portion (22).

3. The optical scanner package of claim 1 or 2, wherein an anti-reflection layer (37) is formed on the first transmission surface (31 a) and/or the second transmission surface (316).

4. The optical scanner package of claim 1, 2 or 3, further comprising an absorption layer (41) formed at portions of the first transmission surface (31 a) and/or the second transmission surface (316) not covered by a transmission area.

5. The optical scanner package of any preceding claim, further comprising through-holes (55) formed in the base substrate within which conductive metal arranged to deliver voltage for rotating the mirror portion is provided.

6. A method of manufacturing an optical scanner package, comprising:
forming an optical scanner device (29) by stacking a mirror portion (22) and comb-electrode structures (25) for rotating the mirror portion (22) on a wafer that forms a base substrate (21);
forming a cavity so that the optical scanner device (29) can include support portions (34) installed on a top surface of the base substrate (21) around the mirror portion (22) and a transmission portion (31) with first and second transmission surfaces (31 a, 31 b) formed on the support portions (34), and processing a cover glass (39) by making the thickness at one side of the support portions (34) less than the thickness at the other side of the support portions (34) so that the first and second transmission surfaces (31 a, 31 b) can be sloped with respect to the top surface of the base substrate (21); and
hermetically sealing the mirror portion (22) in a chip scale by adhering the top surface of the base substrate (21) to bottom surfaces of the support portions (34).

7. The method of claim 6, wherein the forming of the optical scanner device (29) comprises cutting the wafer in columns, the wafer being arranged in a matrix form.

8. The method of claim 6 or 7, wherein the processing of the cover glass (39) comprises:
planarizing and polishing both surfaces of a glass wafer;
forming a plurality of cavities arranged in a matrix form at the bottom surface of the glass wafer;
cutting the glass wafer in columns and preparing a glass bar; and
cutting and polishing a bottom surface of the glass bar by making a thickness at one side of the support portions less than a thickness at the other side of the support portions so that the slope between the transmission surfaces and the top surface of the base substrate can be greater than a maximum rotation angle of the mirror portion.

9. The method of claim 6, 7 or 8, wherein the processing of the cover glass (39) comprises forming an anti-reflection layer (37) on a top surface and/or a bottom surface of the cover glass (39).

10. The method of any of claims 6 to 9, wherein the processing of the cover glass comprises forming an absorption layer (41) at an edge of a top surface and/or a bottom surface of the cover glass (39).

11. The method of any of claims 6 to 10, wherein the hermetically sealing of the mirror portion (22) comprises eutectic-bonding the cover glass (39) and the optical scanner device (29) in a wafer bar shape.
